# FASCICULE DE BREVET EUROPEEN

(11) **EP 3 568 505 B1**
(45) Date de publication et mention de la délivrance du brevet: **02.12.2020**
(21) Numéro de dépôt: 18700980.8
(22) Date de dépôt: 09.01.2018
(51) Int. Cl.: C23C 16/455, C23C 16/52

(54) **CHAMBRE DE TRAITEMENT POUR UN REACTEUR DE DEPOT CHIMIQUE EN PHASE VAPEUR (CVD) ET PROCEDE DE THERMALISATION MIS EN OEUVRE DANS CETTE CHAMBRE**
BEHANDLUNGSKAMMER FÜR EINEN REAKTOR ZUR CHEMISCHEN GASPHASENABSCHEIDUNG (CVD) UND IN DIESER KAMMER AUSGEFÜHRTER THERMALISIERUNGSPROZESS
TREATMENT CHAMBER FOR A CHEMICAL VAPOR DEPOSITION (CVD) REACTOR AND THERMALIZATION PROCESS CARRIED OUT IN THIS CHAMBER

(30) Priorité: 16.01.2017 FR 1750316
(43) Date de publication de la demande: 20.11.2019
(73) Titulaire: Kobus SAS, 38330 Montbonnot-Saint-Martin (FR)
(72) Inventeur: NAL, Patrice, 38000 Grenoble (FR); BOREAN, Christophe, 38660 Le Touvet (FR)
(74) Mandataire: IP Trust
(86) Numéro de dépôt international: PCT/EP2018/050442
(87) Numéro de publication internationale: WO 2018/130516

(56) Documents cités:
- US-A1- 2005 000 430
- US-A1- 2007 175 396
- US-A1- 2009 305 509
- US-A1- 2015 007 770

## Description

### DOMAINE DE L'INVENTION

La présente invention concerne une chambre de traitement pour un réacteur de dépôt chimique en phase vapeur (CVD). Elle vise également un procédé de thermalisation mis en œuvre dans cette chambre.

Le domaine est plus particulièrement celui de la régulation thermique du système de distribution de gaz dans un réacteur CVD et de l'optimisation des transferts thermiques dans un tel réacteur.

### ARRIERE PLAN DE L'INVENTION

Les dépôts de type CVD sont réalisés dans des réacteurs, dans des conditions de vide partiel. Dans certains de ces réacteurs, les espèces réactives (par exemple réactant et précurseur) sont injectées dans une chambre de traitement par l'intermédiaire d'une pièce appelée usuellement douche d'injection (« showerhead ») qui fait face à un substrat à traiter et qui comprend une pluralité de canaux pour injecter les espèces réactives de manière homogène dans le volume au-dessus du substrat.

On connaît par exemple le document WO 2009/0136019 qui décrit un tel réacteur avec une douche d'injection comprenant deux séries de canaux distincts pour injecter les espèces réactives de manière séparée.

Ces types de réacteurs équipés d'une douche d'injection peuvent notamment être utilisés pour mettre en oeuvre des techniques de dépôt de type CVD. Ils peuvent également être utilisés pour mettre en oeuvre des techniques de type CVD pulsé, telles que décrites par exemple dans le document WO 2015/140261**.** Dans ce cas, on utilise une douche à deux groupes de canaux distincts et les espèces réactives sont injectées sous forme d'impulsions déphasées. On peut ainsi par exemple réaliser des dépôts avec une grande conformité, c'est-à-dire une grande uniformité d'épaisseur sur toutes les faces des motifs, avec des vitesses de croissance élevées.

Ces douches d'injection sont des pièces d'usure qui doivent être démontées et changées périodiquement. Or dans le cadre des dépôts CVD pulsés, et des dépôts CVD en général, se pose un problème de thermalisation ou de maintien en température de la douche d'injection des réacteurs. En effet, cette pièce doit être maintenue à une température précise en fonction du procédé mis en oeuvre. Pour cela, de manière habituelle, elle est mise en contact avec une autre pièce du réacteur dont la température est contrôlée. Le transfert de chaleur se fait donc par un contact thermique métal-métal (ou entre matériaux en présence) sous vide, au travers d'une fonction double, à la fois fixation et transfert thermique. Dans ce cas, le transfert thermique se fait essentiellement par conduction au niveau des points de fixation, donc sur des surfaces très faibles, et de manière plus marginale par rayonnement, puisqu'il n'y a pas de conduction thermique dans le vide.

Pour préserver l'intégrité des précurseurs thermosensibles circulant dans la douche d'injection et l'uniformité du dépôt sur le substrat, il est important que la température de cette douche d'injection soit uniforme et constante sur toute sa surface.

Or, une telle douche d'injection est soumise à des apports d'énergie brusques et répétés en fonction des étapes de process, notamment lorsque le substrat, placé sur un support chauffant (« heater »), se rapproche de la douche et que la pression augmente dans la chambre, ou encore lorsqu'un plasma est généré dans la chambre.

Dans ces configurations, le contact entre les matériaux de la douche et de la pièce contrôlée en température sous vide n'est pas approprié pour assurer un transfert de chaleur suffisant avec la zone contrôlée en température. En d'autres termes, la résistance thermique de cette interface est trop élevée pour assurer un transfert de chaleur suffisamment rapide.

Il est par ailleurs connu d'améliorer la conductivité thermique entre des éléments d'assemblage en utilisant un matériau d'interface - tel qu'une graisse thermique - dont la résistance thermique est faible. Toutefois cette solution n'est pas directement applicable dans une chambre de dépôt CVD, car seuls des matériaux inertes au regard du process concerné peuvent être utilisés pour éviter les risques de contamination, et la problématique du vide qui limite la conductance thermique demeure.

Une chambre de traitement CVD comprenant un système de régulation thermique est connue du document US2009/0305509.

Le but de la présente invention est de remédier aux inconvénients rencontrés dans les réacteurs et chambres de traitement CVD de l'art antérieur en termes d'optimisation des transferts thermiques entre les douches d'injection ou de distribution des gaz et les systèmes de régulation thermique, tout en proposant des configurations de couvercle aisément démontables afin de pourvoir accéder sans difficulté au substrat et à la douche d'injection pour son remplacement.

### EXPOSE DE L'INVENTION

Cet objectif est atteint avec une chambre de traitement pour un réacteur de dépôt chimique en phase vapeur (CVD) telle que revendiquée dans les revendications 1-13, cette chambre comprenant, au sein d'un corps définissant une enceinte sous vide partiel, un système d'injection pour injecter des espèces réactives en vue d'être déposées sur un substrat placé sur un élément support, et un système de régulation thermique pour réguler ou maintenir sensiblement constante la température du système d'injection, ce système de régulation thermique présentant une zone d'interface avec le système d'injection.

Suivant l'invention, la chambre de traitement comprend en outre, dans la zone d'interface, au moins une zone de transfert thermique (i) isolée de l'enceinte sous vide partiel par une barrière isolante à la pression et à la diffusion d'espèces contaminantes et (ii) remplie d'un matériau d'interface thermique.

La présence d'un matériau permet l'existence d'un transfert thermique par conduction qui n'existe pas dans le vide. Ce matériau d'interface thermique est de préférence à faible coefficient de résistance thermique.

Le matériau d'interface thermique peut notamment présenter une conductivité thermique égale ou supérieure à celle de l'air (par exemple dans les conditions de températures et de pression de l'environnement du réacteur).

La barrière isolante permet d'éviter les pertes de pression et la diffusion de composés du matériau d'interface thermique dans la chambre de traitement, qui seraient alors des espèces contaminantes.

Grâce à cette nouvelle technique de réalisation procurée par l'invention, il devient possible de réaliser une interface thermique très efficace tout en conservant une bonne maintenabilité.

Ainsi, la présente invention procure une amélioration sensible de la stabilité en température de la douche d'injection des gaz au cours du process, grâce à une meilleure conductance thermique entre la douche et la partie supérieure de la chambre intégrant le système de régulation thermique.

En effet, la présence de ce matériau d'interface thermique permet un transfert thermique par conduction, ce qui n'est pas le cas en présence de vide dans lequel seuls les transferts thermiques par rayonnement, beaucoup plus limités, sont possibles.

L'interface thermique ainsi réalisé permet d'évacuer la chaleur absorbée provenant de l'élément support ou porte-substrat par le système d'injection des gaz lors du rapprochement de ce dernier et lors de la montée en pression de la chambre au moment de l'injection des gaz.

Outre le fait d'assurer un bon contact thermique, la présente invention est simple à mettre en œuvre, ne nécessite pas de canaux de fluides supplémentaires, et elle ne rend pas plus complexe les opérations de maintenance.

Dans une forme préférée de réalisation d'une chambre selon l'invention, le système de régulation thermique est partie intégrante d'un couvercle du réacteur, ce couvercle étant pourvu d'un orifice d'entrée des espèces réactives.

Le système d'injection est avantageusement solidaire du couvercle via la zone d'interface et le système de régulation thermique, de sorte que ce système d'injection est aisément accessible par amovibilité du couvercle.

Cette configuration intégrée du couvercle de la chambre de traitement contribue à faciliter le remplacement du système d'injection des gaz.

Selon l'invention, la chambre de traitement comprend une zone de transfert thermique délimitée par au moins deux barrières isolantes imbriquées.

La zone de transfert thermique ainsi délimitée peut par exemple présenter une forme annulaire dans le cas d'une chambre de traitement de géométrie cylindrique.

Dans une configuration particulière d'une chambre de traitement selon l'invention, la chambre de traitement comprend plusieurs zones de transfert thermique réparties dans la zone d'interface et délimitées chacune par une barrière isolante.

Cette barrière isolante est agencée pour réaliser autour de la zone de transfert thermique une ou des zones d'étanchéité permettant d'avoir une pression différente entre l'enceinte sous vide partiel et la zone de transfert thermique. La barrière isolante peut par exemple comprendre un ou plusieurs rangs de joints agencés pour séparer la zone de transfert thermique sous pression atmosphérique de l'enceinte sous vide partiel.

Le système de régulation thermique est pourvu d'un ou plusieurs trous prévus pour mettre le matériau d'interface thermique sous pression atmosphérique.

Dans une chambre de traitement selon l'invention comprenant en outre des moyens radiofréquences prévus pour générer un plasma par application d'un potentiel radiofréquence (RF) entre le système d'injection et le substrat, cette chambre comprend en outre des moyens pour isoler électriquement le système de régulation thermique du reste du corps de la chambre qui est à la masse.

Le système d'injection est avantageusement agencé sous la forme d'une douche d'injection ou de distribution comprenant une pluralité de canaux prévus pour injecter des espèces réactives de manière homogène dans l'enceinte sous vide partiel.

Cette douche de distribution peut aussi comprendre deux séries de canaux distincts pour injecter les espèces réactives de manière séparée. Cette injection séparée présente notamment un intérêt pour des dépôts en continu.

Les espèces réactives peuvent être injectées sous la forme d'impulsions déphasées, de façon à réaliser un dépôt CVD pulsé. Dans ce cas, les impulsions génèrent des variations fortes et rapides des conditions de pression et de température dans la chambre qui rendent d'autant plus nécessaire une optimisation des transferts thermiques.

Dans une configuration particulière d'une chambre de traitement selon l'invention, cette chambre peut en outre comprendre des moyens pour régler la hauteur de l'élément support du substrat dans l'enceinte.

Suivant un autre aspect de l'invention, il est proposé un procédé pour thermaliser un système d'injection d'espèces réactives au sein d'une chambre de traitement pour un réacteur de dépôt chimique en phase vapeur (CVD) tel que revendiqué dans les revendications 14-17, cette chambre comprenant en outre, au sein d'un corps définissant une enceinte sous vide partiel, un système d'injection pour injecter des espèces réactives en vue d'être déposées sur un substrat placé sur un élément support, ce procédé comprenant une régulation thermique pour réguler ou maintenir sensiblement constante la température du système d'injection, cette régulation thermique étant réalisée depuis une partie du corps faisant couvercle et présentant une zone d'interface avec le système d'injection.

Selon l'invention, le procédé de thermalisation comprend au niveau de la zone d'interface :
- un transfert thermique par conduction, via une zone de transfert thermique contenant un matériau d'interface thermique, entre le système d'injection et la partie supérieure faisant couvercle,
- une isolation à la pression et à la diffusion d'espèces contaminantes de la zone de transfert thermique par rapport à l'enceinte sous vide partiel.

Le procédé de thermalisation selon l'invention peut être mis en œuvre dans un réacteur équipé d'un système d'injection sous la forme d'une douche d'injection ou de distribution. Cette douche d'injection peut avantageusement comprendre deux séries de canaux distincts pour injecter les espèces réactives de manière séparée. Les espèces réactives peuvent être injectées sous la forme d'impulsions déphasées.

### BREVE DESCRIPTION DES DESSINS

D'autres caractéristiques et avantages apparaîtront dans la description qui va suivre de modes de réalisation d'une chambre de traitement selon l'invention, donnés à titre d'exemples non limitatifs, en référence aux dessins annexés dans lesquels :
- la figure 1 présente un schéma synoptique d'une chambre de traitement pour un réacteur de dépôt chimique en phase vapeur représentatif de l'art antérieur ;
- la figure 2 présente un schéma synoptique d'un premier mode de réalisation d'une chambre de traitement pour un réacteur de dépôt chimique en phase vapeur selon l'invention ;

- la figure 3 est une vue agrandie partielle de la zone d'interface de la chambre de traitement illustrée par la figure 2 ; et
- la figure 4 présente un schéma synoptique d'un second mode de réalisation d'une chambre de traitement pour un réacteur de dépôt chimique selon l'invention.

### DESCRIPTION DETAILLEE DE MODES DE REALISATION DE L'INVENTION

Pour les différents modes de mise en œuvre, les mêmes références seront utilisées pour des éléments identiques ou assurant la même fonction par souci de simplification de la description.

Ces modes de réalisation étant nullement limitatifs, on pourra notamment considérer des variantes de l'invention ne comprenant qu'une sélection de caractéristiques décrites ou illustrées par la suite isolées des autres caractéristiques décrites ou illustrées (même si cette sélection est isolée au sein d'une phrase comprenant ces autres caractéristiques), si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, et/ou avec seulement une partie des détails structurels si cette partie uniquement est suffisante pour conférer un avantage technique ou à différencier l'invention par rapport à l'état de la technique antérieure.

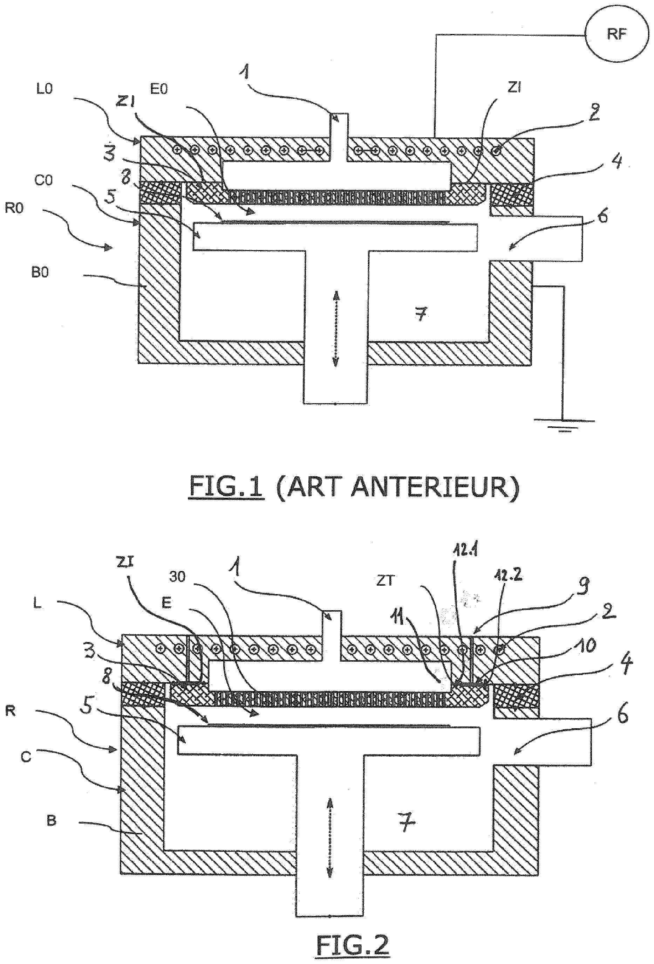

La figure 1 illustre schématiquement un réacteur R0 de dépôt chimique en phase vapeur CVD représentatif de l'état de la technique. Ce réacteur comprend une chambre de traitement C0 qui est prévue pour réaliser un dépôt en mode CVD ou CVD pulsé sur un substrat 8 placé sur un élément support ou porte-substrat 5 et est pourvue d'une douche d'injection 3, par exemple du type à deux groupes de canaux tel que divulgué dans le document WO 2009/0136019**.** La douche d'injection 3 est une pièce d'usure qui doit être remplacée périodiquement.

Ce réacteur R0 de l'art antérieur peut optionnellement mettre en oeuvre une génération d'un plasma par application d'un potentiel radiofréquence (RF) entre la douche d'injection 3 et le substrat 8 placé sur le porte-substrat 5.

La chambre de traitement C0 comporte un corps B0 définissant une enceinte E0 qui est maintenue sous vide partiel, et elle est pourvue sur sa partie supérieure d'un couvercle ou « lid » L0 amovible et comportant un orifice 1 par lequel les gaz entrent dans l'enceinte E0.

Le couvercle L0 peut être porté au potentiel RF lorsqu'il équipe un réacteur CVD mettant en œuvre une génération de plasma. Ce couvercle L0 est maintenu en température au moyen d'un système de régulation thermique 2 équipé par exemple de résistances chauffantes, ou fonctionnant par induction électromagnétique, ou bien encore mettant en œuvre un circuit parcouru par un fluide caloporteur tel qu'un mélange d'eau désionisée et d'éthylène glycol ou tel que le fluide de transfert thermique de marque Galden® commercialisé par le Groupe Solvay.

Le système de régulation thermique 2 a pour fonction principale de maintenir la douche 3 à température constante.

Un élément isolateur électrique 4 est prévu pour séparer la partie de la chambre C0 portée au potentiel RF du reste de la chambre C0 qui est à la masse.

Les gaz sous-produits de la réaction sont évacués par un orifice 6 ménagé latéral dans le corps B de la chambre de traitement C0.

Le porte-substrat 5 maintient le substrat 8 en température et assure également une fonction électrique car, selon le type de chambre, il peut être soumis à un potentiel flottant, à la masse, ou polarisé à une tension continue ou alternative. Le porte substrat 5 peut être porté à des températures allant de -40°C à +800°C.

La hauteur du porte-substrat 5 peut être ajustée pour optimiser les performances du procédé et procéder au chargement/déchargement de la plaque de substrat. Le porte-substrat 5 évolue dans une partie 7 de la chambre C0 et les parois de cette partie 7 sont maintenues à un potentiel électrique nul. Il est à noter que le rapprochement du porte-substrat 5 et la montée en pression de la chambre C0 au moment de l'injection des gaz génèrent des échanges thermiques importants avec la douche d'injection 3 qui peuvent modifier la température de cette dernière.

Avec un tel réacteur, il est par exemple possible de réaliser des dépôts à haute température de polysilicium ou de silicium amorphe sur le substrat 8. Ces procédés nécessitent des températures de substrat comprises entre 600°C et 700°C et une pression voisine du tiers de la pression atmosphérique, ce qui contribue à une forte conductance thermique entre le système de régulation thermique 2 et la douche d'injection 3. Si la douche 3 n'est pas maintenue à une température suffisamment basse, par exemple de l'ordre de 80°C, il peut se produire une détérioration du précurseur avant la zone dédiée à la réaction, ce qui conduit à une génération excessive de particules qui est très dommageable pour le process.

Dans un autre type de dépôt, on peut vouloir déposer un polymère, tel que le parylène, qui nécessite une sublimation du précurseur (à environ 100°C) puis une pyrolyse à une température supérieure à 500°C permettant d'activer le précurseur dans une zone située en amont de la chambre. Le précurseur activé est ensuite acheminé vers la chambre pour se déposer sur un substrat à température ambiante. La différence de température entre le précurseur activé et le substrat est un des points clés de la réaction. Si la douche d'injection des gaz située au-dessus du substrat n'est pas maintenue à une température suffisamment élevée, le dépôt aura lieu sur la douche au lieu du substrat. Ce dépôt n'étant pas nettoyable *in situ,* le temps moyen d'utilisation de la chambre entre deux ouvertures pour nettoyage est très faible.

On va maintenant décrire, en référence à la figure 2, un premier mode de réalisation d'une chambre de traitement pour un réacteur CVD selon l'invention. A l'exception des différences décrites ci-après, cette chambre C comporte des caractéristiques communes avec la chambre C0 précédemment décrite en référence à la figure 1 et elle peut être mise en œuvre de manière similaire.

La chambre C diffère notamment de la chambre C0 en ce qu'elle comprend en outre, au niveau de la zone d'interface ZI entre la douche d'injection 3 et le système de régulation thermique 2, une zone de transfert thermique ZT isolée de l'enceinte sous vide partiel E.

Cette zone de transfert thermique ZT est délimitée et séparée de l'enceinte E par une barrière isolante à la pression et à la diffusion d'espèces chimiques. Elle est remplie d'un matériau d'interface thermique 10 qui assure un transfert thermique par contact et conduction, et donc dont le coefficient de résistance thermique est très faible par rapport à celui qui serait atteint avec une interface sous vide telle que décrite par exemple en relation avec la figure 1.

La zone de transfert thermique ZT peut comprendre un lamage qui définit un volume libre ou contraint. Elle peut être réalisée sous la forme de plusieurs zones délimitées chacune par une barrière isolante, réparties dans la zone d'interface ZI, ou encore sous la forme d'une zone entre deux barrières isolantes sur tout le périmètre de la zone d'interface ZI.

Le matériau d'interface thermique 10 peut être de l'air emprisonné, de la mousse, une graisse conductrice ou bien encore un métal malléable.

La zone de transfert thermique n'est pas soumise au vide et contient de l'air et/ou un autre matériau. Cet air demeure emprisonné lors de la mise sous vide partiel de la chambre et assure le transfert thermique par conduction. La pression dans la zone de transfert reste donc égale ou supérieure à la pression atmosphérique au montage.

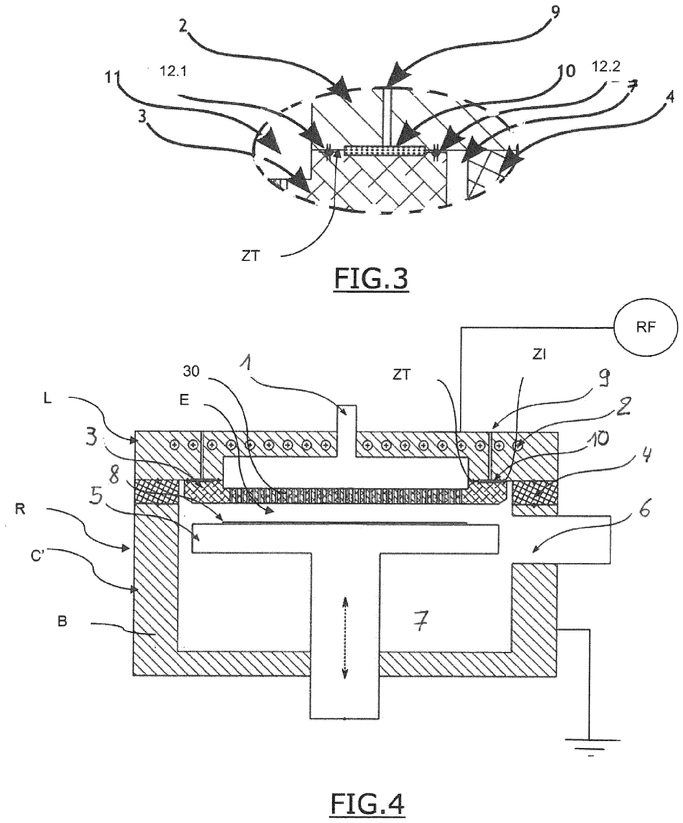

Le couvercle L de la chambre de traitement C comporte un jeu de trous 9 réalisés pour mettre l'interface de transfert thermique à la pression atmosphérique, comme l'illustre la figure 3 qui est une vue agrandie partielle de la zone de transfert thermique.

La zone de transfert thermique ZT comporte deux zones d'étanchéité 12.1, 12.2 permettant d'avoir une pression différente entre une zone 11 de répartition des gaz avant la douche d'injection 3 et la zone de contact thermique contenant le matériau d'interface thermique 10 placé sous pression atmosphérique via le trou 9 ménagé à travers le système de régulation thermique 2. Les deux zones d'étanchéité 12.1, 12.2 constituent la barrière isolante enfermant la zone de transfert thermique ZT et peuvent être réalisées sous la forme de rangs de joints permettant de séparer la partie sous pression atmosphérique de la partie sous basse pression ou vide partiel. Les joints utilisés peuvent être des joints toriques dans des gorges, ou des joints métalliques supportant des hautes températures.

On va maintenant décrire, en référence à la figure 4, un second mode de réalisation d'une chambre C' de traitement pour un réacteur CVD selon l'invention. Outre l'ensemble des éléments constitutifs communs avec la chambre C illustrée par la figure 2 et qui vient d'être décrite, la chambre C' comprend en outre un système de génération d'un plasma par application d'un potentiel radiofréquence RF entre la douche d'injection 3 et le substrat 8 disposé sur le porte-substrat 5. Ce système de génération plasma fait par exemple partie intégrante de la douche d'injection 3. Le couvercle L est relié à une source radiofréquence tandis que la partie inférieure du corps B de la chambre de traitement C' est reliée à une masse (potentiel nul). La douche d'injection 3 est reliée électriquement au couvercle L via la zone d'interface ZI et elle est isolée électriquement de la partie inférieure du corps B au moyen de l'élément isolateur 4.

Une chambre de traitement selon l'invention peut présenter une grande variété de configurations correspondant chacune à un type particulier de dépôt ou de substrat ou à une application particulière. Ainsi, dans le cadre de la présente invention et à titre d'exemples non limitatifs, on pourra considérer des combinaisons des différentes configurations suivantes de dépôt, de chambre et de régulation thermique :

### Configurations CVD

- CVD
   ∘ douche de distribution comprenant une pluralité de canaux
   ∘ douche de distribution comprenant deux groupes de canaux distincts
   ∘ espèces réactives injectées de manière homogène
- CVD puisé :
   ∘ douche de distribution comprenant deux groupes de canaux distincts
   ∘ espèces réactives injectées sous forme d'impulsions déphasées

### types de dépôt

- dépôt à haute température de polysilicium ou de silicium sur le substrat
- dépôt d'un polymère sur le substrat

### Chambre

- pression gazeuse variant dans la chambre en fonction des séquences d'injection des espèces réactives
- plasma RF généré dans la chambre

### Régulation thermique

- résistances chauffantes
- induction électromagnétique
- fluide caloporteur

Bien sûr, l'invention n'est pas limitée aux exemples qui viennent d'être décrits et de nombreux aménagements peuvent être apportés à ces exemples sans sortir du cadre de l'invention. Bien entendu, les différentes caractéristiques, formes, variantes et modes de réalisation de l'invention peuvent être associés les uns avec les autres selon diverses combinaisons dans la mesure où ils ne sont pas incompatibles ou exclusifs les uns des autres.

## Revendications

1. Chambre de traitement (C) pour un réacteur (R) de dépôt chimique en phase vapeur (CVD), comprenant, au sein d'un corps (B) définissant une enceinte (E) sous vide partiel, un système (3) pour injecter des espèces réactives en vue d'être déposées sur un substrat (8) placé sur un élément support (5), et un système de régulation thermique (2) pour réguler ou maintenir sensiblement constante la température dudit système d'injection (3), ledit système de régulation thermique(2) présentant une zone d'interface (ZI) avec ledit système d'injection (3),
la chambre de traitement comprend en outre, dans ladite zone d'interface (ZI), au moins une zone de transfert thermique (ZT) (i) isolée de ladite enceinte (E) sous vide partiel par une barrière isolante à la pression et à la diffusion d'espèces contaminantes et (ii) remplie d'un matériau d'interface thermique (10),
**caractérisée en ce que** la zone de transfert thermique (ZT) est délimitée par au moins deux barrières isolantes imbriquées,
la barrière isolante étant agencée pour réaliser autour de la zone de transfert thermique (ZT) une ou des zones d'étanchéité permettant d'avoir une pression différente entre l'enceinte sous vide partiel (E) et ladite zone de transfert thermique (ZT),
et **en ce que** le système de régulation thermique (2) est pourvu d'un ou plusieurs trous (9) prévus pour mettre le matériau d'interface thermique (10) sous pression atmosphérique.

2. Chambre (C) selon la revendication 1, **caractérisée en ce que** le matériau d'interface thermique est à faible coefficient de résistance thermique.

3. Chambre (C) selon l'une des revendications 1 ou 2, **caractérisée en ce que** le matériau d'interface thermique présente une conductivité thermique égale ou supérieure à celle de l'air.

4. Chambre (C) selon la revendication 1, **caractérisée en ce que** le système de régulation thermique (2) est partie intégrante d'un couvercle (L) du réacteur (R), ledit couvercle (L) étant pourvu d'un orifice (1) d'entrée des espèces réactives.

5. Chambre (C) selon la revendication 4, **caractérisée en ce que** le système d'injection (3) est solidaire du couvercle (L) via la zone d'interface (ZI) et le système de régulation thermique (2), de sorte que ledit système d'injection (3) est accessible par amovibilité dudit couvercle.

6. Chambre (C) selon la revendication 1, **caractérisée en ce que** la zone de transfert thermique ainsi délimitée est une zone annulaire.

7. Chambre (C) selon l'une quelconque des revendications précédentes, **caractérisée en ce qu'**elle comporte plusieurs zones de transfert thermique réparties dans la zone d'interface et délimitées chacune par une barrière isolante.

8. Chambre selon la revendication 1, **caractérisée en ce que** la barrière isolante comprend un ou plusieurs rangs de joints agencés pour séparer la zone de transfert thermique (ZT) sous pression atmosphérique de l'enceinte sous vide partiel (E).

9. Chambre (C) selon l'une quelconque des revendications précédentes, comprenant en outre des moyens radiofréquences prévus pour générer un plasma par application d'un potentiel radiofréquence (RF) entre le système d'injection (3) et le substrat (8), **caractérisée en ce qu'**elle comprend en outre des moyens (4) pour isoler électriquement le système de régulation thermique (2) du reste du corps (B) de la chambre (C) qui est à la masse.

10. Chambre (C) selon l'une quelconque des revendications précédentes, **caractérisée en ce que** le système d'injection est agencé sous la forme d'une douche de distribution (3) comprenant une pluralité de canaux (30) prévus pour injecter des espèces réactives de manière homogène dans l'enceinte sous vide partiel (E).

11. Chambre selon la revendication 10, **caractérisée en ce que** la douche de distribution (3) comprend deux séries de canaux distincts pour injecter les espèces réactives de manière séparée.

12. Chambre selon la revendication 10, **caractérisée en ce que** la douche de distribution comprend deux séries de canaux distincts pour injecter les espèces réactives sous la forme d'impulsions déphasées.

13. Chambre selon l'une quelconque des revendications précédentes, **caractérisée en ce qu'**elle comprend en outre des moyens pour régler la hauteur de l'élément support (5) du substrat (8) dans l'enceinte sous vide partiel (E).

14. Procédé pour thermaliser un système (3) d'injection d'espèces réactives au sein d'une chambre de traitement pour un réacteur (R) de dépôt chimique en phase vapeur (CVD), cette chambre comprenant en outre, au sein d'un corps (B) définissant une enceinte sous vide partiel (E), un système d'injection pour injecter des espèces réactives en vue d'être déposées sur un support placé sur un élément support, ce procédé comprenant une régulation thermique pour réguler ou maintenir sensiblement constante la température dudit système d'injection (3), ladite régulation thermique étant réalisée depuis une partie dudit corps (B) faisant couvercle et formant un système de régulation thermique (2), le système de régulation thermique (2) présentant une zone d'interface (ZI) avec ledit système d'injection (3),
**caractérisé en ce qu'**il comprend au niveau de ladite zone d'interface (3):
- un transfert thermique par conduction, via une zone de transfert thermique (ZT) contenant un matériau d'interface thermique (10), entre ledit système d'injection (3) et ladite partie supérieure faisant couvercle (L), ladite zone thermique (ZT) étant délimitée par au moins deux barrières isolantes imbriquées et
- une isolation à la pression et à la diffusion d'espèces contaminantes de ladite zone de transfert thermique (ZT) par rapport à ladite enceinte sous vide partiel (E), la barrière isolante étant agencée pour réaliser autour de la zone de transfert thermique (ZT) une ou des zones d'étanchéité permettant d'avoir une pression différente entre l'enceinte sous vide partiel (E) et ladite zone de transfert thermique (ZT), le système de régulation thermique (2) étant pourvu d'un ou plusieurs trous (9) prévus pour mettre le matériau d'interface thermique sous pression atmosphérique.

15. Procédé selon la revendication 14, mis en œuvre dans un réacteur (R) équipé d'un système d'injection sous la forme d'une douche de distribution (3).

16. Procédé selon la revendication 15, mis en œuvre avec une douche de distribution comprenant deux séries de canaux distincts pour injecter les espèces réactives de manière séparée.

17. Procédé selon la revendication 16, **caractérisé en ce que** les espèces réactives sont injectées sous la forme d'impulsions déphasées.

18. Réacteur de dépôt chimique en phase vapeur (CVD) intégrant une chambre de traitement selon l'une quelconque des revendications 1 à 13.

## Patentansprüche

1. Behandlungskammer (C) für einen Reaktor (R) zur chemischen Gasphasenabscheidung (CVD), umfassend, innerhalb eines Gehäuses (B), das einen Teilvakuumraum (E) definiert, ein System (3) zum Einspritzen reaktiver Spezies, die auf einem Substrat (8) abgeschieden werden sollen, das auf einem Trägerelement (5) angeordnet ist, und ein thermisches Regelungssystem (2) zum Regeln oder Aufrechterhalten einer im Wesentlichen konstanten Temperatur des Einspritzsystems (3), wobei das thermische Regelungssystem (2) eine Grenzflächenzone (ZI) mit dem Einspritzsystem (3) aufweist, wobei die Behandlungskammer ferner in der Grenzflächenzone (ZI) mindestens eine Wärmeübertragungszone (ZT) umfasst, die (i) durch eine isolierende Barriere gegenüber Druck und Diffusion kontaminierender Spezies von dem Teilvakuumraum (2) isoliert ist und (ii) mit einem thermischen Grenzflächenmaterial (10) befüllt ist, **dadurch gekennzeichnet, dass** die Wärmeübertragungszone (ZT) durch mindestens zwei ineinander verschachtelte isolierende Barrieren begrenzt ist, wobei die isolierende Barriere so angeordnet ist, dass sie um die Wärmeübertragungszone (ZT) herum eine oder mehrere Dichtzonen erzeugt, die es ermöglichen, einen unterschiedlichen Druck zwischen dem Teilvakuumraum (E) und der Wärmeübertragungszone (ZT) zu erreichen, und dass das thermische Regelungssystem (2) mit einem oder mehreren Löchern (9) versehen ist, die dazu bestimmt sind, das thermische Grenzflächenmaterial (10) unter Atmosphärendruck zu setzen.

2. Kammer (C) nach Anspruch 1, **dadurch gekennzeichnet, dass** das thermische Grenzflächenmaterial einen niedrigen Wärmewiderstandskoeffizienten besitzt.

3. Kammer (C) nach einem der Ansprüche 1 oder 2, **dadurch gekennzeichnet, dass** das thermische Grenzflächenmaterial eine Wärmeleitfähigkeit gleich oder größer als die von Luft aufweist.

4. Kammer (C) nach Anspruch 1, **dadurch gekennzeichnet, dass** das thermische Regelungssystem (2) ein integraler Bestandteil einer Abdeckung (L) des Reaktors (R) ist, wobei die Abdeckung (L) mit einer Einlassöffnung (1) für die reaktiven Spezies versehen ist.

5. Kammer (C) nach Anspruch 4, **dadurch gekennzeichnet, dass** das Einspritzsystem (3) über die Grenzflächenzone (ZI) und das thermische Regelungssystem (2) fest mit der Abdeckung (L) verbunden ist, derart, dass das Einspritzsystem (3) durch Entfernen der Abdeckung zugänglich ist.

6. Kammer (C) nach Anspruch 1, **dadurch gekennzeichnet, dass** die so abgegrenzte Wärmeübertragungszone eine ringförmige Zone ist.

7. Kammer (C) nach einem der vorhergehenden Ansprüche, **dadurch gekennzeichnet, dass** sie mehrere Wärmeübertragungszonen umfasst, die innerhalb der Grenzflächenzone verteilt sind und jeweils durch eine isolierende Barriere abgegrenzt sind.

8. Kammer nach Anspruch 1, **dadurch gekennzeichnet, dass** die isolierende Barriere eine oder mehrere Reihen von Dichtungen umfasst, die so angeordnet sind, dass sie die Wärmeübertragungszone (ZT) unter atmosphärischem Druck von dem Teilvakuumraum (E) trennen.

9. Kammer (C) nach einem der vorhergehenden Ansprüche, ferner umfassend Hochfrequenzmittel zur Erzeugung eines Plasmas durch Anlegen eines Hochfrequenzpotentials (RF) zwischen dem Einspritzsystem (3) und dem Substrat (8), **dadurch gekennzeichnet, dass** sie ferner Mittel (4) zur elektrischen Isolierung des termischen Regelungssystems (2) vom übrigen Gehäuse (B) der Kammer (C) umfasst, das geerdet ist.

10. Kammer (C) nach einem der vorhergehenden Ansprüche, **dadurch gekennzeichnet, dass** das Einspritzsystem in Form einer Verteilungsdusche (3) angeordnet ist, die mehrere Kanäle (30) umfasst, die zum homogenen Einspritzen reaktiver Spezies in den Teilvakuumraum (E) vorgesehen sind.

11. Kammer nach Anspruch 10, **dadurch gekennzeichnet, dass** die Verteilungsdusche (3) zwei Reihen von getrennten Kanälen zum separaten Einspritzen der reaktiven Spezies umfasst.

12. Kammer nach Anspruch 10, **dadurch gekennzeichnet, dass** die Verteilungsdusche zwei Reihen von getrennten Kanälen zum Einspritzen der reaktiven Spezies in Form von phasenverschobenen Impulsen umfasst.

13. Kammer nach einem der vorhergehenden Ansprüche, **dadurch gekennzeichnet, dass** sie ferner Mittel zur Einstellung der Höhe des Trägerelements (5) des Substrats (8) im Teilvakuumraum (E) umfasst.

14. Verfahren zur Thermalisierung eines Systems (3) zum Einspritzen reaktiver Spezies in eine Behandlungskammer für einen Reaktor (R) zur chemischen Gasphasenabscheidung (CVD), wobei diese Kammer ferner in einem Gehäuse (B), das einen Teilvakuumraum (E) definiert, ein Einspritzsystem zum Einspritzen reaktiver Spezies im Hinblick auf ihre Abscheidung auf einem auf einem Trägerelement angeordneten Träger umfasst, wobei dieses Verfahren eine thermische Regelung umfasst, um die Temperatur des Einspritzsystems (3) zu regeln oder im Wesentlichen konstant zu halten, wobei die thermische Regelung von einem Teil des Gehäuses (B) aus erfolgt, der als Abdeckung dient und ein thermisches Regelungssystem (2) bildet, wobei das thermische Regelungssytem (2) eine Grenzflächenzone (ZI) mit dem Einspritzsystem (3) aufweist, **dadurch gekennzeichnet, dass** es an der Grenzflächenzone (3) Folgendes umfasst:
- eine Wärmeübertragung durch Leiten, über eine Wärmeübertragungszone (ZT), die ein thermisches Grenzflächenmaterial (10) enthält, zwischen dem Einspritzsystem (3) und dem oberen Teil, der als Abdeckung (L) dient, wobei die Wärmeübertragungszone (ZT) durch mindestens zwei ineinander verschachtelte isolierende Barrieren begrenzt ist, und
- eine Isolierung gegenüber Druck und Diffusion kontaminierender Spezies der Wärmeübertragungszone (ZT) in Bezug auf den Teilvakuumraum (E), wobei die isolierende Barriere so angeordnet ist, dass sie um die Wärmeübertragungszone (ZT) herum eine oder mehrere Dichtungszonen erzeugt, die einen unterschiedlichen Druck zwischen dem Teilvakuumraum (E) und der Wärmeübertragungszone (ZT) ermöglichen, wobei das thermische Regelungssystem (2) mit einem oder mehreren Löchern (9) versehen ist, die dazu bestimmt sind, das thermische Grenzflächenmaterial unter Atmosphärendruck zu setzen.

15. Verfahren nach Anspruch 14 zur Durchführung in einem Reaktor (R), der mit einem Einspritzsystem in Form einer Verteilungsdusche (3) ausgestattet ist.

16. Verfahren nach Anspruch 15, das mittels einer Verteilungsdusche durchgeführt wird, umfassend zwei Reihen von getrennten Kanälen zum separaten Einspritzen der reaktiven Spezies.

17. Verfahren nach Anspruch 16, **dadurch gekennzeichnet, dass** die reaktiven Spezies in Form von phasenverschobenen Impulsen eingespritzt werden.

18. Reaktor zur chemischen Gasphasenabscheidung (CVD), umfassend eine Behandlungskammer nach einem der Ansprüche 1 bis 13.

## Claims

1. Treatment chamber (C) for a chemical vapor deposition (CVD) reactor (R), comprising, within a body (B) defining an enclosure (E) under partial vacuum, a system (3) for injecting reactive species with a view to being deposited on a substrate (8) placed on a support element (5), and a temperature control system (2) for controlling the temperature of said injection system (3) or keeping said temperature substantially constant, said temperature control system (2) having an interface zone (ZI) with said injection system (3), the treatment chamber further comprising, in said interface zone (ZI), at least one thermal transfer zone (ZT) which is (i) insulated from said enclosure (E) under partial vacuum by a barrier that provides insulation from the pressure and the diffusion of contaminating species and (ii) filled with a thermal interface material (10), **characterized in that** the thermal transfer zone (ZT) is delimited by at least two interlocked insulating barriers, the insulating barrier being arranged so as to produce one or more sealing zones around the thermal transfer zone (ZT) making it possible to have a different pressure between the enclosure (E) under partial vacuum and said thermal transfer zone (ZT), and **in that** the temperature control system (2) is provided with one or more holes (9) for putting the thermal interface material (10) under atmospheric pressure.

2. Chamber (C) according to claim 1, **characterized in that** the thermal interface material has a low coefficient of thermal resistance.

3. Chamber (C) according to either claim 1 or claim 2, **characterized in that** the thermal interface material has a thermal conductivity equal to or greater than that of air.

4. Chamber (C) according to claim 1, **characterized in that** the temperature control system (2) is an integral part of a cover (L) of the reactor (R), said cover (L) being provided with an opening (1) for inputting reactive species.

5. Chamber (C) according to claim 4, **characterized in that** the injection system (3) is rigidly connected to the cover (L) via the interface zone (ZI) and the temperature control system (2) such that said injection system (3) is accessible by removal of said cover.

6. Chamber (C) according to claim 1, **characterized in that** the thermal transfer zone thus delimited is an annular zone.

7. Chamber (C) according to any of the preceding claims, **characterized in that** it comprises a plurality of thermal transfer zones distributed in the interface zone and each delimited by an insulating barrier.

8. Chamber according to claim 1, **characterized in that** the insulating barrier comprises one or more rows of seals arranged so as to separate the thermal transfer zone (ZT) under atmospheric pressure from the enclosure (E) under partial vacuum.

9. Chamber (C) according to any of the preceding claims, further comprising radiofrequency means designed to generate a plasma by applying a radiofrequency potential (RF) between the injection system (3) and the substrate (8), **characterized in that** it further comprises means (4) for electrically insulating the temperature control system (2) from the rest of the body (B) of the chamber (C) which is grounded.

10. Chamber (C) according to any of the preceding claims, **characterized in that** the injection system is arranged in the form of a distribution shower (3) comprising a plurality of channels (30) designed to inject reactive species homogeneously into the enclosure (E) under partial vacuum.

11. Chamber according to claim 10, **characterized in that** the distribution shower (3) comprises two series of distinct channels for injecting the reactive species separately.

12. Chamber according to claim 10, **characterized in that** the distribution shower comprises two series of distinct channels for injecting the reactive species in the form of phase-shifted pulses.

13. Chamber according to any of the preceding claims, **characterized in that** it further comprises means for adjusting the height of the support element (5) of the substrate (8) in the enclosure (E) under partial vacuum.

14. Method for thermalizing a system (3) for injecting reactive species within a treatment chamber for a chemical vapor deposition (CVD) reactor (R), said chamber further comprising, within a body (B) defining an enclosure (E) under partial vacuum, an injection system for injecting reactive species with a view to being deposited on a support placed on a support element, said method comprising temperature control for controlling the temperature of said injection system (3) or keeping said temperature substantially constant, said temperature control being carried out from a part of said body (B) forming a cover and forming a temperature control system (2), the temperature control system (2) having an interface zone (ZI) with said injection system (3), **characterized in that** it comprises at said interface zone (3):
- thermal transfer by conduction, via a thermal transfer zone (ZT) containing a thermal interface material (10), between said injection system (3) and said upper part forming a cover (L), said thermal zone (ZT) being delimited by at least two interlocked insulating barriers and
- insulation from the pressure and the diffusion of contaminating species of said thermal transfer zone (ZT) with respect to said enclosure (E) under partial vacuum, the insulating barrier being arranged so as to produce one or more sealing zones around the thermal transfer zone (ZT) making it possible to have a different pressure between the enclosure (E) under partial vacuum and said thermal transfer zone (ZT), the temperature control system (2) being provided with one or more holes (9) for putting the thermal interface material under atmospheric pressure.

15. Method according to claim 14, implemented in a reactor (R) equipped with an injection system in the form of a distribution shower (3).

16. Method according to claim 15, implemented with a distribution shower comprising two series of distinct channels for injecting the reactive species separately.

17. Method according to claim 16, **characterized in that** the reactive species are injected in the form of phase-shifted pulses.

18. Chemical vapor deposition (CVD) reactor incorporating a treatment chamber according to any of claims 1 to 13.
